# EUROPEAN PATENT SPECIFICATION

(11) **EP 0 390 523 B1**
(45) Date of publication and mention of the grant of the patent: **27.12.1995**
(21) Application number: 90303287.8
(22) Date of filing: 28.03.1990
(51) Int. Cl.: H01L 51/00, H01L 31/04, H01L 31/08

(54) **An optical element utilizing a molecular heterojunction**
Einen molekularen Heteroübergang aufweisendes optisches Element
Elément optique utilisant une héterojonction moléculaire

(30) Priority: 29.03.1989 JP 79238/89
(43) Date of publication of application: 03.10.1990
(73) Proprietor: MITSUBISHI DENKI KABUSHIKI KAISHA, Tokyo (JP)
(72) Inventor: Isoda, Satoru, c/o Mitsubishi Denki K.K., Amagasaki-shi, Hyogo-ken (JP); Ueyama, Satoshi, c/o Mitsubishi Denki K.K., Amagasaki-shi, Hyogo-ken (JP); Kawakubo, Hiroaki, c/o Mitsubishi Denki K.K., Amagasaki-shi, Hyogo-ken (JP); Maeda, Mitsuo, c/o Mitsubishi Denki K.K., Amagasaki-shi, Hyogo-ken (JP)
(74) Representative: Beresford, Keith Denis Lewis

(56) References cited:
- CA-A- 1 169 055
- US-A- 4 725 513
- US-A- 4 764 415
- Solar Energy 1977 vol.19 no.5 pgs 567-70. Appl.Phys.Lett 1992 vol.61 no.1 pgs.116-118. Sov.Phys-Solid State 1972 vol.14 no.3 pgs 790-794. J.Chem Phys 1981 vol.75 no.5 pgs 2429-2431. Bull.Electrotech.Lab 1977 vol.41 no.6 pgs 31-34

## Description

The present invention relates to an optical element used in an integrated circuit. More particularly, the present invention relates to an optical element having a superior photoconductive property and photovoltaic effect.

Conventionally, there is much research and development on the photo-electric effect of inorganic and organic semiconductor. This effect is utilized in an optical element in a variety of fields. As photo-electric effect of semiconductor, the photoconduction property and photovoltaic effect are well known and these effects are utilized in optical elements in a variety of application fields.

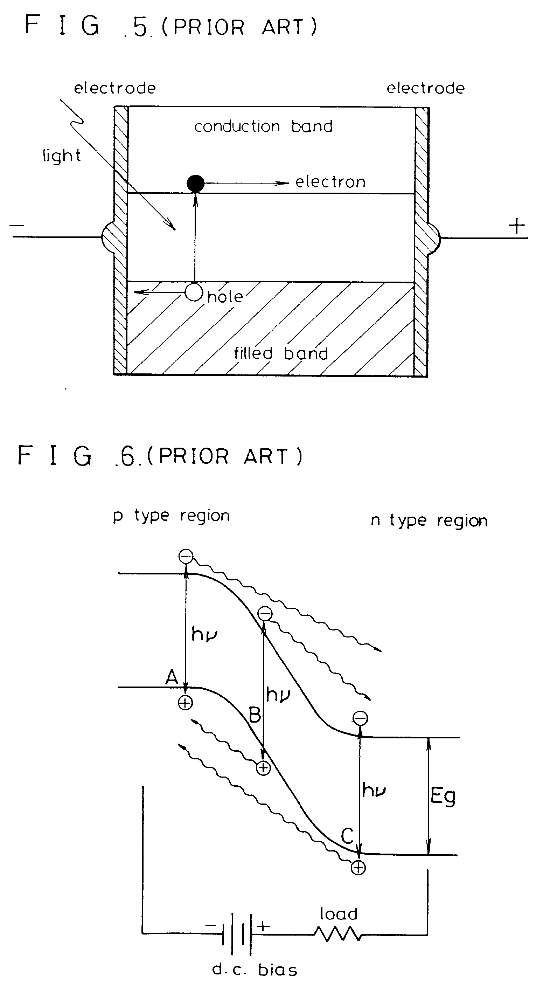

As an example of material occurring photoconduction property, the crystal of cadmium sulfide and the like are well known. As shown in figure 5 which is recited in "Electronic Physics Engineering", by Masaharu Aoki, pp360, when the cadmium sulfide crystal is irradiated with light, the energy of the light excites an electron to the conduction band from the filled band, whereby a free electron and a free hole are generated. When the electron and the hole pass through the crystal between the electrodes or between the electrode and the crystal, the photoconduction property is exhibited. This process is as shown in figure 5.

As an example of an element utilizing the photovoltaic effect, a photo cell including a semiconductor PN junction, a photodiode which is used for detecting light and the like are well known.

Figure 6 shows an example of the physical process of a semiconductor photodiode recited on pp 304 of "Foundation of Opto-electronics", by A. YARIV, translated by Kunio Tada and Takeshi Kamiya. The physical process will be described hereinafter along the expression of "Foundation of Opto-electronics". In figure 6, at a region A, the incident photon is absorbed at the p type region, and a hole and an electron are generated. If the interval between this place and the depletion layer is less than the diffusion distance, the electron reaches the depletion layer at high probability and is drifted under the electric field, and transverses the depletion layer. At a region C, when the photon is absorbed at a place close to the depletion layer in the n type region, the hole generated in response to the absorption is diffused toward the depletion layer and is drifted to transverse the depletion layer. It is possible that the photon is absorbed in the depletion layer at a region B. Then, the generated hole and electron are both drifted under an electric field in reverse directions to each other so that they reach the p type side or n type side, respectively.

The photovoltaic effect using organic compound occurs almost by that the Schottky barrier produced between the metal electrode and the organic compound layer generates carriers in response to the light absorption. An example of such type is disclosed in detail in D.A.Seanor "Electrical Properties of Polymers," Chap. 4.

The conventional optical element, especially that utilizing the photoconduction property and photovoltaic effect is constituted as described above. The photoconduction property is utilized in a photosensitive plate or an optical sensor of electronic photograph and the photovoltaic effect is utilized in a solar cell or a photosensor. The semiconductor PN junction can be produced in a MOS structure and a fine patterning is possible. Thereby, a CCD image sensor of more than one million pixels is put into practice.

By the way, a high frequency response characteristics is important in an optical element. That is, an optical element of high sensitivity and high speed response property is requested. In the conventional photoconduction element a band structure of semiconductor is utilized and in the photovoltaic effect element a semiconductor PN junction or a metal-semiconductor Schottky barrier is utilized. Therefore, in view of the fact that the diffusion time of carriers generated in the p type or n type region is finite and that the width of the space charge layer at the pn junction portion or the Schottky barrier portion is finite, a delay occurs in the light response due to the running time of the carrier. Therefore, in order to enhance the speed of the light response in the conventional element, it is necessary to shorten the time for the carrier passage or thin the width of the space charge layer or the semiconductor layer. However, when the thickness of the element is small, the number of carriers is reduced and the sensitivity is lowered.

CA-A-1169055 discloses a photovoltaic cell and in particular such a cell wherein the active ingredient of the device is a "molecular p-n junction".

US-A-4725513 discloses an electroluminescent device comprising a luminescent layer. The luminescent layer comprises a mixed monomolecular film of at least one electroluminescent organic compound and at least one organic compound which is different in electro-negativity from said organic compound or a built-up film thereof.

US-A-4764415 discloses layers constituting a rectifier or transistor element respectively formed by oxidation-reduction substances so that a redox potential difference is provided between adjacent layers. The oxidation-reduction substances are selected from biogenic redox protein, pseudo-redox protein and the like. The element is implemented in hyperfine size in molecular level, so that an integrated circuit of super-high density can be attained by using the element.

Sol. Energy 1977, vol. 19, No. 5, pgs 567-70 discusses the sensitization of a totally illuminated thin layer photogalvanic cell based on iron-thiazine photoredox reaction. Photogalvanic output is obtained upon illumination of a single solution containing two photoredox dyes and three sensitizers with monochromatic light throughout the wavelength range approximately 375-700 nm.

Appl. Phys. Lett 1992, Vol. 61, No. 1, pgs 116-8 discusses the photoelectric properties in microscopic p-n junctions of organic semiconductors especially photodiodes containing microscopic p-n junctions of organic dyes using the Langmuir-Blodgett technique.

Sov. Phys-Sol State 1972, vol. 14, No. 3, pgs 790-4 discusses the impurity-level energies in magnesium phthalocyanine films and especially external photoeffect and conductivity measurements to find the positions of the impurity levels of oxygen and iron and aluminium in magnesium phthalocyanine films.

J.Chem. Phys. 1981, vol. 75, No. 5, pgs 2429-31 discusses the absence of photochromic switching in semiconducting films of thioindigo.

Bull Electo.Lab 1977, Vol. 41, No. 6, pgs 31-34 discusses the photoelectric effects in lipid bilayer membranes containing Schiff bases of retinal.

It is an object of the present invention to provide an optical element of high speed and high sensitivity and enabling utilization as a three dimensional element or a hybrid element, using two kinds of redox material films such as hetero accumulative LB films, having different redox potentials.

Other objects and advantages of the present invention will become apparent from the detailed description given hereinafter; it should be understood, however, that the detailed description and specific embodiment are given by way of illustration only, since various changes and modifications within the scope of the invention will become apparent to those skilled in the art from this detailed description.

According to the present invention there is provided a photoelectric conversion element having the features of claim 1.

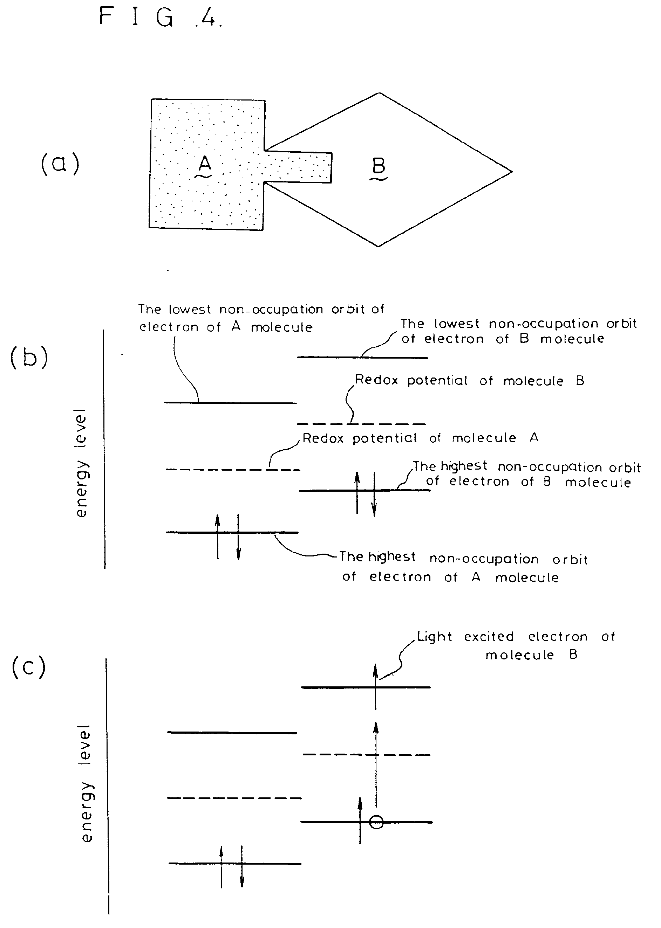

In the present invention, the complex comprising two kinds of redox material having different redox potentials forming a junction, shows a function of an optical element such as photoconduction property or photovoltaic effect. As is shown by the schematic view of the A-B type redox material compound and the relation between the energy levels thereof in Figures 4a, 4b and 4c, the electron on the highest orbit of the molecule B can be excited to the lowest non-occupation orbit of the molecule B by the light irradiation in the compound comprising the redox material molecules A and B junctioned to each other. The difference in the energy level of the electron corresponding to the A and B molecular layer can be controlled, therefore, it is possible to occur the photoconduction property and photovoltaic effect. Then, the energy levels of the A and B molecular layers may have a wide band broadening because of the crystallinity in the molecular layer.

In the accompanying drawings:-
Figure 1 is a diagram schematically showing a cross-sectional view of an optical element in accordance with an embodiment of the present invention;
Figure 2 is an exploded perspective view analytically showing the optical element;
Figure 3 is a graph showing the voltage vs current characteristics of the optical element of Figure 1;
Figure 4(a) is a diagram schematically showing the A-B type redox material compound and Figure 4(b) and (c) are diagrams showing the energy levels of the compound;
Figure 5 is a diagram for explaining the photoconduction property;
Figure 6 is a diagram for explaining the photovoltaic effect; and
Figure 7 is a diagram showing the electron transfer system of the internal film of mitochondrion.

An embodiment of the present invention will be described in detail with reference to the drawings.

By the way, in the internal film of biomembrane of micro-organism and that of mitochondrion of higher organism, there are a plurality of kinds of enzyme protein extracting electrons from the reductive chemical substance such as H₂, organic acid, NAD(P)H (Nicotineamide Adenine Dinucleotide (Phosphate)), as well as a plurality of kinds of protein having an electron transfer function transferring extracted electron toward a predetermined direction of the biomembrane (hereinafter called as "electron transfer protein"). These electron transfer protein molecules are embedded in the biomembrane in a predetermined orientation and they are arranged in a special molecular arrangement so that the electron transfer occurs between the molecules.

As discussed above, the electron transfer protein are arranged as in a chain with a precise arrangement in the biomembrane and therefore, it is possible to flow the electron along the protein chain and the movement of the electron can be controlled at the molecular level.

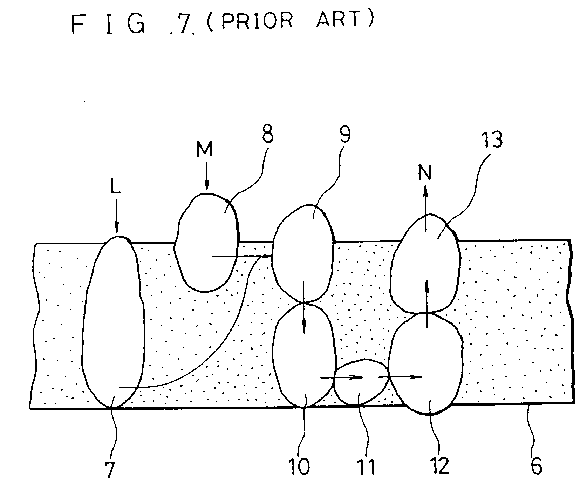

Figure 7 schematically shows an electron transfer system in the internal film of mitochondrion as an example of electron transfer protein chain. In figure, reference numeral 6 designates an internal film of mitochondrion, reference numerals 7 to 13 designate electron transfer protein molecule, and the electrons extracted from the NADH (in figure (L)) and succinic acid (in figure (M)), which are reductive organism, by NADH-Q reduction enzyme 7 and succinic acid dehydrogenaze respectively are transferred on a path from NADH-Q reduction enzyme 7, succinic acid dehydrogenaze 8, cytochrome b(9), cytochrome c1( 10), cytochrome c(11), cytochrome a(12), and cytochrome a3(13), and finally it is handed to the oxygen at the outlet side N, thereby generating a H₂O molecule.

The electron transfer protein shown in Figure 7 occurs an oxidation/reduction (hereinafter referred to as "redox") reaction in the transfer of electron and it is possible to flow the electron from the negative level to the positive level of the redox potential of the respective electron transfer protein.

In midst of electron transfer protein, there is one in which the potential of electron changes by that the electron is excited by irradiated with light.

According to the recent finding, electron transfer protein complex capable of transferring an electron can be produced by not only combining electron transfer protein molecules existing in the same organism but also combining electron transfer protein molecules existing in different kinds of organisms.

Therefore, by using two kinds of redox material A and B having appropriate redox potentials and selecting one among them in which the electron is excited by light and accumulating these in a two layer of A-B, it may be possible to produce a molecular heterojunction generating a photocurrent and a photovoltage by irradiation of light.

In accordance with an optical element according to the present invention, an optical element comprises a film comprising first redox material, a second redox material film comprising second redox material having a different redox potential from that of the first redox material, connected to the first redox material film, electrodes respectively connected to the first redox material film and the second redox material film. The state of electron of the first and second redox material molecule are controlled by that the materials are irradiated by light, thereby occurring the photoconduction property or generating a photovoltage.

Whilst the first and second redox material are selected from flavin derivative, porphyrin derivative, viologen, methylene blue, indophenol, phenosafranine, annulene, neutral red, toluidine blue, gallocyanin, indigo, and pheno thiazine, flavin derivatives and porphyrin derivatives are preferred from the point of view that the redox reaction occurs stably because they are organisms simulating material and that the electron mobility speed is fast.

As said flavin derivative, the compound which is represented by the general formula (I) is raised.

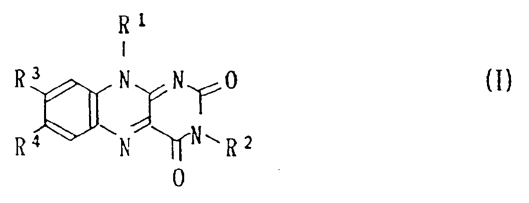

The R¹ and R² in the general formula (I) are respectively hydrogen atom or alkyl group comprising the combination in the following.
(i) R¹ is a hydrogen atom or an alkyl group having 1 to 5 carbon atoms
   R² is an alkyl group having 15 to 20 carbon atoms
(ii) R¹ is an alkyl group having 6 to 20 carbon atoms
   R² is an alkyl group having 6 to 20 carbon atoms
(iii) R¹ is an alkyl group having 15 to 20 carbon atoms
   R² is a hydrogen atom or an alkyl group having 1 to 5 carbon atoms

Because R¹ and R² are each group of such as the above-described combination, the polarity can be controlled. This makes it possible to produce a uniform monomolecular film on the water surface.

Furthermore, R³ and R⁴ are each a substituent including a hydrogen atom, an alkyl group having 1 to 5 carbon atoms, and a carbonyl group, methylthio acetic acid group, or methylthio succinic acid group. Since R³ and R⁴ are these group, the number of negative ions per one molecule can be varied to be 0, 1, or 2. Further, the position of isoalloxazin ring in the monomolecular film can be controlled. Furthermore, the orientation of the isoalloxazin ring in the monomolecular film can be controlled.

As a preferred embodiment of the flavin derivative, 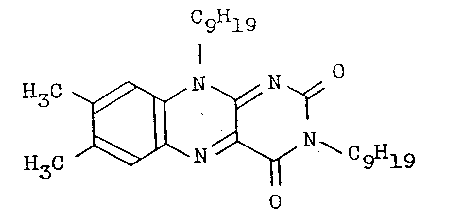 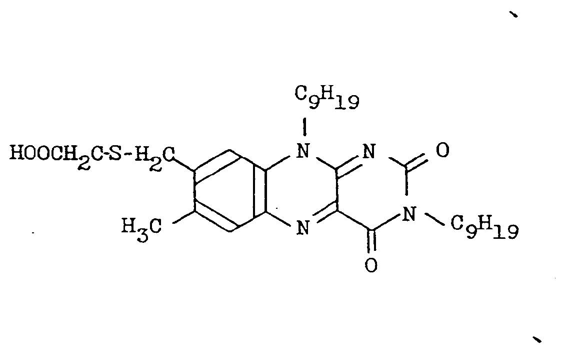 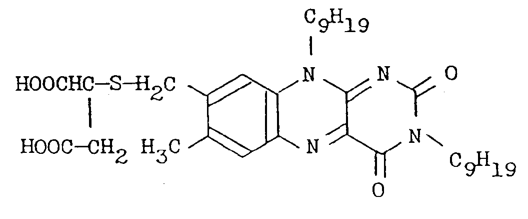
are raised.

As said porphrin derivative, compounds represented by the general formula (II): 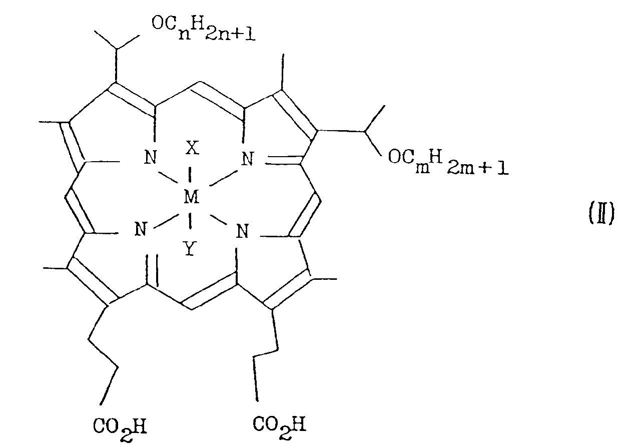
the general formula (III): 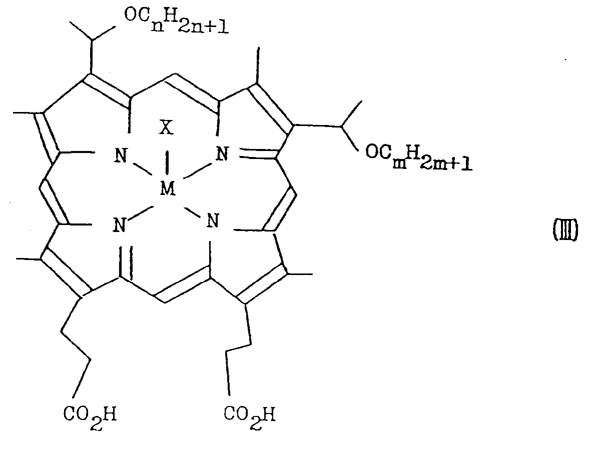
or the general formula (IV): 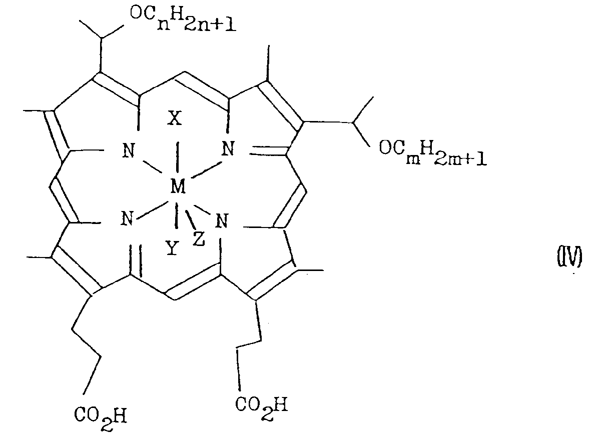
are raised.

The M in the general formulae (II) to (IV) is Fe or Ru. Because M is Fe or Ru, the redox reaction reacting between two valence bond state and three valence bond state occurs stably.

The X, Y, and Z in the general formulae (II) to (IV) are ligand against M, and the structure (II), (III), and (IV) can be obtained dependent on the kinds and the valence bond number of M. M are each a halogen atom, CO, -OCOCH₃, pyridine, imidazole, or P(OR⁵)₃ or PR⁵₃(R⁵ is a lower alkyl group of C1 to C4). When X, Y, and Z are not these atoms or groups, the stability of the state of two valence bonds or the three valence bonds is low and it is likely to deteriorate. Herein, X and Y are the same or different.

The m and n in the general formulae (II) to (IV) are integers from 5 to 20, and preferably from 5 to 15. In a case where m and n are less than 5, the hydrophobic property of the compound which is represented by the general formulae (II) to (IV) are insufficient and it is impossible to produce a monomolecular film which is suitable for the production of LB film. On the other hand, when it exceeds 20, the hydrophobic alkyl chain of the compound which is represented by the general formulae (II), (III), and (IV) is too long and while producing the built-up film comprising monomolecular films, the distance between the porphyrin rings between the layers is too long and the electron transfer characteristics is lowered. The m and n is the same or different.

The alkali metallic salt of porphyrin metal complex is alkali metallic salt of compound represented by the general formulae (II) to (IV). As the alkali metal, Na, K and the like are raised. The alkali metallic salt of porphyrin metal complex of the present invention may be one in which one of the carboxyl group in the general formulae (II) to (IV) is salt or two of them are salt.

As a preferable example of the porphyrin derivative, the following is raised:

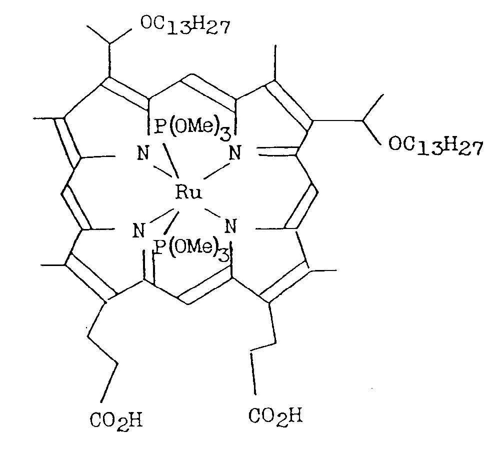

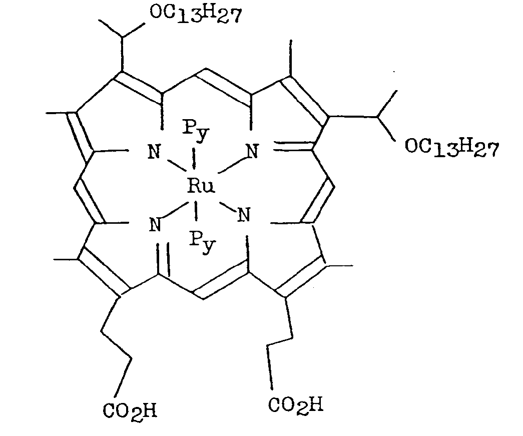

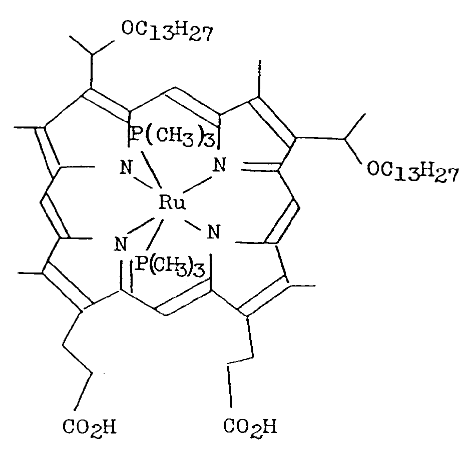

### (Herein, Py represents pyridine.)

For the optical element of the present invention, first redox material and second redox material having different redox potential are used. The difference in the redox potential is 0.3 to 1.0 V in view of accelerating the electron movement speed and the photoelectric conversion efficiency.

There is no restriction in the combination of the first redox material and the second redox material is selected from the material recited as usable in the present invention, but it is preferable to use either of the porphyrin derivative and flavin derivative as the first redox material and the other as the second redox material. It is because the redox potential difference is appropriate and the redox reaction proceeds stably, thereby resulting in a high electron transfer speed.

The first redox material film and the second redox material film are preferable to have thickness of 1 to 50 nm (10 to 500 Ångstroms), especially 1 to 10 nm (10 to 100 Ångstroms) in view of reducing the electron running time and enhancing the response speed as an element. As such film, a film produced by Langmuir-Blodgett method, Molecular Beam Epitaxy method, a vacuum deposition method, and CVD (Chemical Vapor Deposition) method may be raised. A single molecular film obtained by LB method and a built-up film of about 2 to 10 layers are preferable in view of built-up in the form of holding a stable order structure of monomolecular film of organic molecule. It is found possible to control the orientation by suppressing the film pressure at the production of the film by the LB method, and the flavin LB film and porphyrin LB film both show good orientation at the film pressure of 25 to 32.5 mN·m⁻¹(mili Newton per meter).

The detail of the LB method is recited in such as
(a) Iwing Langmuir, Journal of Japanese Society of Electrical Engineers, Vol.55, pp. 204 to 213, April 1935,
(b) K.Blodgett, Journal of American Chemical Society, Vol. 57, pp. 1007, 1935,
(c) Michio Sugi, etc., Solid State Physics, Vol.17, pp. 744 to 752, 1982,
(d) Journal of Colloid and Interface Science Vol.68, pp. 471 to 477, 1979.

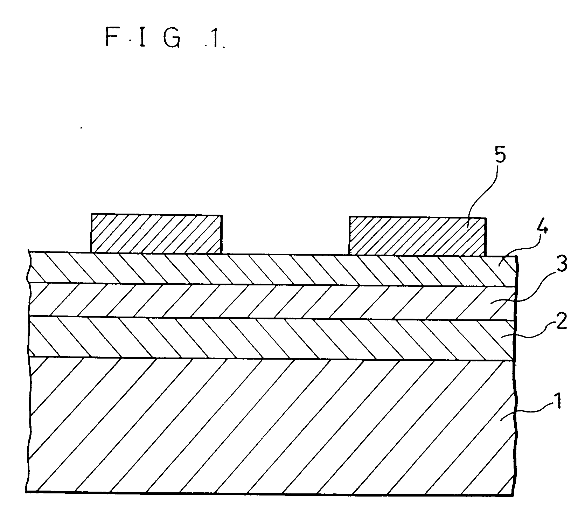

The optical element of the present invention comprises the first redox material film 3 and the second redox material film 4 being connected to each other and the first electrode 2 being connected to the first redox material film 3 and the second electrode 5 being connected to the second redox material film 4 as shown in Figure 1.

The electrodes serve to apply a predetermined voltage across the redox materials, and a metallic electrode comprising such as Ag, Au, Al or a transparent electrode comprising such as SnO₂, ITO is used.

The optical element of the present invention may be one having more than three kinds of redox material films.

The connection is easily obtained by producing the first redox material film by such as LB method, MBE method, and CVD method and thereafter producing the second redox material film by such as LB method. As the light for irradiation, light of wavelength which is absorbed by the first and second redox material film is used. For example, in a case of flavin derivative, light of wavelength 250 to 520 nm is used. The way of light irradiation may be usual, not subjected to particular restrictions.

In the optical element of the present invention constructed as described above, the photo-current generating efficiency is high and the photo-voltage generated is high because two kinds of redox material having different redox potentials are used and the heterojunction film generating carriers in response to the light irradiation is utilized. Furthermore, by using the monomoleclar film or the monomolecular built-up film produced by the LB method as the redox material film, an optical element comprising quite a thin film is produced and a high speed light response is enabled. Furthermore, because the LB film can be produced independent on the crystallinity of the substrate, the utilization as a three dimensional element or as a hybrid element combined with the conventional semiconductor elements such as those utilizing Si is possible.

An example of production method of the optical element in accordance with the present invention will be described.

At first, an electrode is produced on the substrate by such as ion beam method, molecular beam method, deposition method, or CVD method. Next, by such as LB method, first redox material film is produced so as to be in contact with the electrode and a second redox material film is produced thereon by such as LB method. In a case where more than three kinds of redox material films are produced, that is, an element of A - B - A redox material type is produced, a redox material film is further produced. Next, an electrode is produced so as to be in contact with the redox material film at the most upper surface, thereby completing an optical element of the present invention.

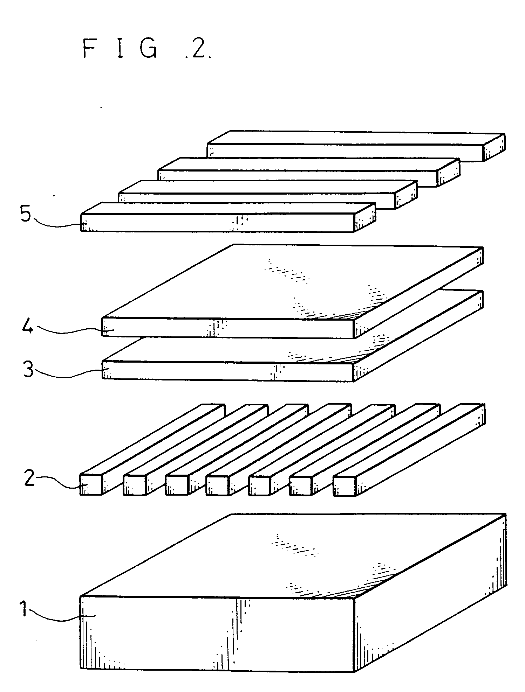

An experimental example of the present invention will be described in greater detail with reference to Figures 1 and 2.

Figure 1 shows a schematic cross-sectional view showing a device in which an optical element of the present invention is incorporated and Figure 2 shows an exploaded view showing elements of the device of figure 1 in a disassembled state.

### [Example]

Firstly, an electrode 2 comprising a plurality of aluminum lines 100 nm (1000 Ångstroms) thickness and 1mm width in parallel are produced on the glass substrate 1.

By utilizing this substrate, a porphyrin derivative (RPPH) represented by the following formula: 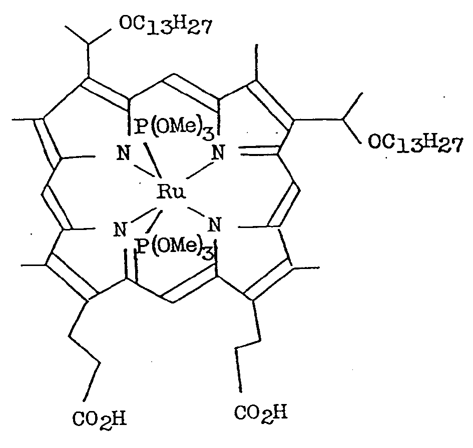
is laminated by three molecular layers at film pressure of 27.5mN · m,⁻¹ by the LB method, thereby producing the first redox material film 3.

Next, the flavin derivative represented by the following formula: 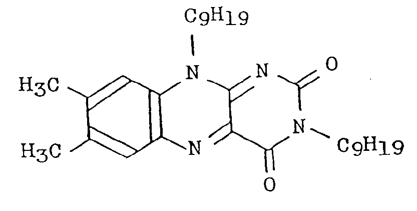
is laminated on the substrate comprising the substrate 1, electrode 2, and film 3 by the LB method by four molecular layers at film pressure of 30 mN · m⁻¹, thereby producing the second redox material film 4. The second redox material film 4 is laminated and connected to the first redox material film 3. The difference of the redox potential between first redox material and second redox material is 700 mV.

Next, a translucent second electrode 5 comprising a plurality of aluminum lines of 10 nm (100 Ångstrom) thickness and 1mm width in parallel with each other is produced on the direction vertical to the electrode 2.

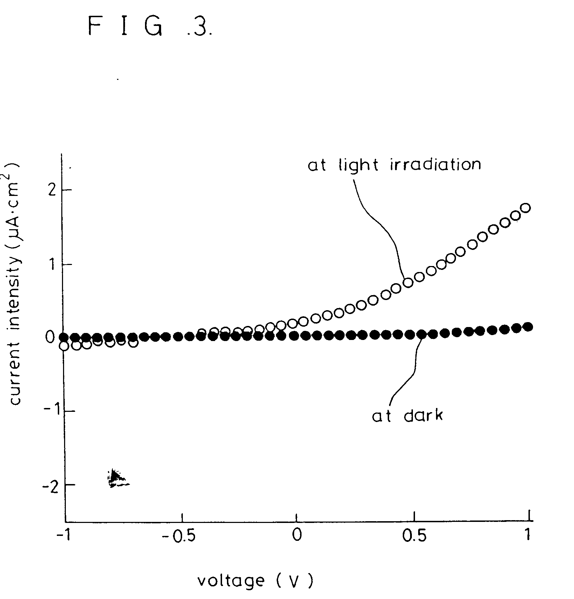

The voltage vs current characteristics are measured in cases where the optical element produced as described above is irradiated with the light of wavelength 450 nm and of power approximately 450 micro W. The result is shown in Figure 3.

From Figure 3, it is apparent that quite a larger current flows when it is irradiated with light than when it is dark. A voltage is applied to the upper layer translucent electrode 5 with grounding the underlying electrode 2. It is found that a large current flows when a voltage + 1 V is applied.

In the above-illustrated example the monomolecular accumulative film of porphyrin derivative and the monomolecular accumulative film of flavin derivative are used for the first redox material film and the second redox material film, respectively, but these LB films may be monomolecular films. Furthermore, it may be that either of the two redox material films is a LB film and the other is a redox material film other than a LB film or the both are redox material films other than a LB film. Furthermore, the experimental example may be of A-B type two layer structure but it may be of A-B-A type multi-layer structure.

As is evident from the foregoing description, an optical element performing an operation similar to that of the conventional semiconductor photodiode such as of p-n junction type is realized by one having a hyperfine molecular level size and an optical image sensor capable of realizing high density and high speed can be obtained. Furthermore, the element of the present invention is easy in accumulating redox material films regardless of the nature of the underlying substrate. This eases constitution of a three dimensional element. This also eases constitution of a hybrid element comprising combination with elements of conventional Si semiconductor or compound semiconductor such as GaAs.

## Claims

1. A method of producing a photoelectric conversion element having a molecular heterojunction, comprising:
providing a first electrode (2);
forming on said first electrode a first layer structure (3) of a thickness between 1 and 50 nm consisting of one or more ordered monomolecular layers of a first organic redox material comprising any of flavin derivative, porphyrin derivative, viologen, methylene blue, indophenol, phenosafranine, annulene, neutral red, toluidine blue, gallocyanin, indigo, and pheno thiazine;
forming on said first layer structure a second layer structure (4) in contact with said first layer structure (3) as a separate and discrete layer structure, which second layer structure (4) also is of a thickness between 1 and 50 nm consisting of one or more ordered monomolecular layers of a second organic redox material which comprises any of flavin derivative, porphyrin derivative, viologen, methylene blue, indophenol, phenosafranine, annulene, neutral red, toluidine blue, gallocyanin, indigo, and pheno thiazine and which differs from said first redox material by a redox potential of between 0.3 to 1.0 V, said first and second organic redox materials forming a heterojunction between them, one only of said first and second redox structures being excitable by light, and
applying on said second layer structure a second electrode (5),
whereby in the resulting conversion element the presence of incident light on said one structure produces a photocurrent or a photovoltage between the electrodes (2,5).

2. A photo-electric conversion element having a first electrode (2), a first layer structure (3) of a thickness between 1 and 50 nm consisting of one or more ordered monomolecular layers of a first organic redox material on said first electrode and comprising any of flavin derivative, porphyrin derivative, viologen, methylene blue, indophenol, phenosafranine, annulene, neutral red, toluidine blue, gallocyanin, indigo, and pheno thiazine; a second layer structure (4) in contact with said first layer structure (3) being a separate and discrete layer structure on said first layer structure, which second layer structure (4) also is of a thickness between 1 and 50 nm and consists of one or more ordered monomolecular layers of a second organic redox material which comprises any of flavin derivative, porphyrin derivative, viologen, methylene blue, indophenol, phenosafranine, annulene, neutral red, toluidine blue, gallocyanin, indigo, and pheno thiazine and which differs from said first redox material by a redox potential of between 0.3 and 1.0 V, one only of said first and second redox materials being excitable by light, and a second electrode (5) on said second layer structure (4), said element being so adapted that the presence of incident light on said one structure produces a photocurrent or a photovoltage between the electrodes.

3. A photoelectric conversion element as claimed in claim 2, characterised in that
said first layer structure (3) consists of a flavin derivative redox material;
said second layer structure (2) consists of a porphyrin derivative redox material,
said flavin derivative is represented by the following general formula (I): 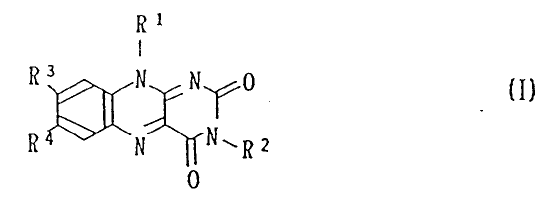 where R¹, R² are each a hydrogen atom or an alkyl group which comprises the combination of the following:
(i) R¹ is a hydrogen atom or an alkyl group having 1 to 5 carbon atoms
R² is an alkyl group having 15 to 20 carbon atoms
(ii) R¹ is an alkyl group having 6 to 20 carbon atoms
R² is an alkyl group having 6 to 20 carbon atoms
(iii) R¹ is an alkyl group having 15 to 20 carbon atoms
R² is a hydrogen atom or an alkyl group having 1 to 5 carbon atoms,
and R³ and R⁴ are each a substituent including a hydrogen atom, an alkyl group having 1 to 5 carbon atoms, or a carbonyl group, a methylthio acetic acid group, or a methylthio succinic acid group,and
said porphyrin derivative is a porphyrin metal complex, or an alkali metallic salt of a porphyrin metal complex, and is represented by one of the following formulae (II), (III) or (IV): 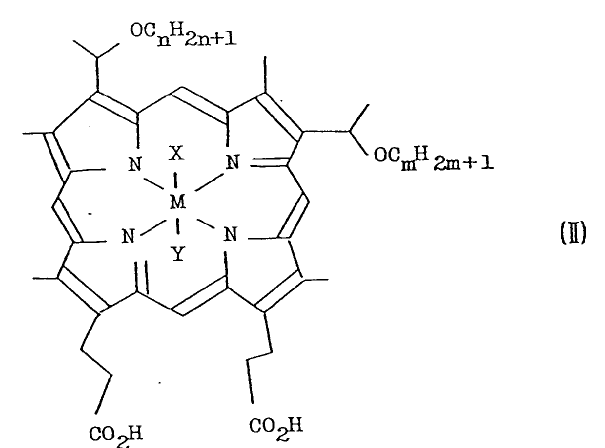 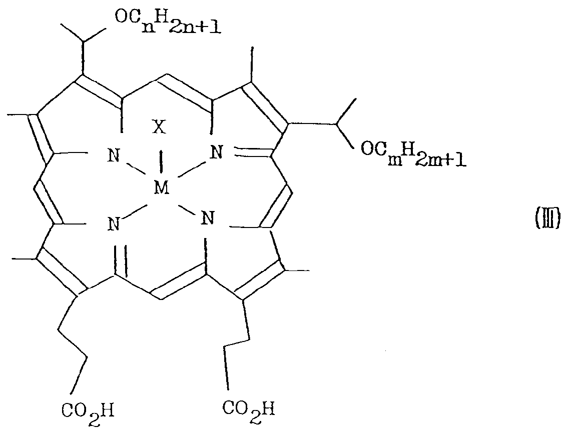 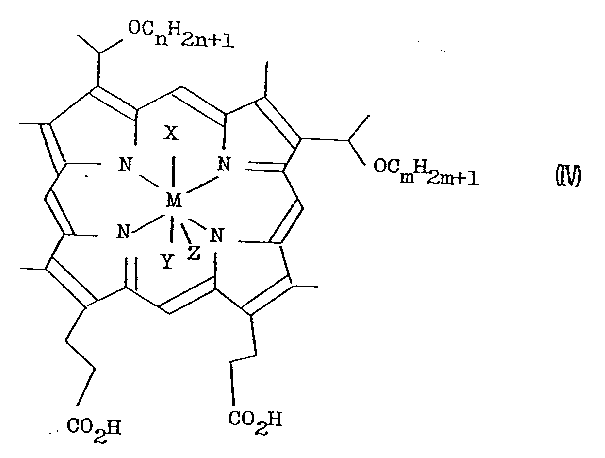 where M is Fe or Ru, X, Y, and Z and each a ligand against M, and the structure of (II), (III), (IV) can be obtained dependent on the kinds and the valence bond number of M, which are, each a halogen atom, CO, -OCOCH₃, pyridine, imidazole, P(OR⁵)₃, or PR⁵₃(R⁵ represents lower alkyl group of C1 to C5), and X and Y are the same or different and m and n are the same or different.

4. An photoelectric conversion element as claimed in claim 3 wherein:
said first layer structure (3) consists of four mono-molecular layers of a flavin derivative redox material represented by the following formula: 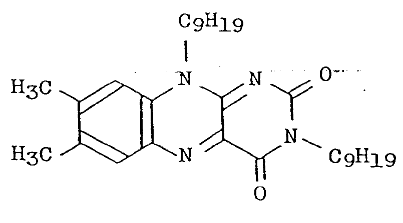 said second layer structure (2) consists of three mono-molecular layers of a porphyrin derivative redox material represented by the following formula:

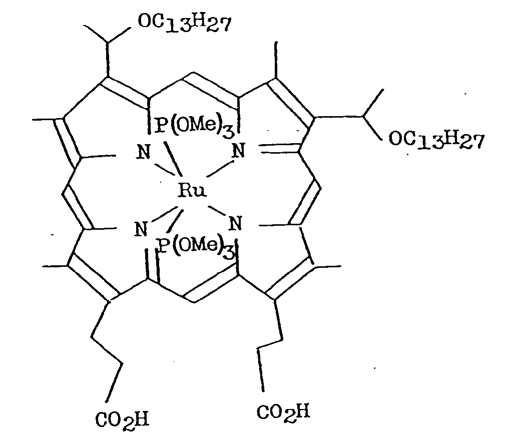

5. An photoelectric conversion element as claimed in any one of claims 2-4, characterised in that
the first and the second electrode material comprises a combination of one or two of the following materials, one electrode being made of a light transmissive semi-transparent material made of Al, Ag, Au, indium tin oxide, SnO₂.

## Patentansprüche

1. Verfahren zur Herstellung eines photoelektrischen Umwandlungselements mit einem molekularen Heteroübergang, welches folgendes umfaßt:
Bereitstellung einer ersten Elektrode (2);
Ausbildung eines ersten Schichtenaufbaus (3) mit einer Dicke zwischen 1 und 50 nm auf der ersten Elektrode, welcher aus einer oder mehreren geordneten, monomolekularen Schichten eines ersten organischen Redoxmaterials besteht, welches irgendein Flavinderivat, Porphyrinderivat, Viologen, Methylenblau, Indophenol, Phenosafranin, Annulen, Neutralrot, Toluidinblau, Gallocyanin, Indigo und Phenothiazin umfaßt;
Ausbildung eines in Kontakt mit dem ersten Schichtenaufbau (3) stehenden, zweiten Schichtenaufbaus (4) auf dem ersten Schichtenaufbau, in Form eines separaten und diskreten Schichtenaufbaus, wobei der zweite Schichtenaufbau (4) ebenfalls eine Dicke zwischen 1 und 50 nm aufweist, aus einer oder mehreren geordneten, monomolekularen Schichten eines zweiten organischen Redoxmaterials besteht, welches irgendein Flavinderivat, Porphyrinderivat, Viologen, Methylenblau, Indophenol, Phenosafranin, Annulen, Neutralrot, Toluidinblau, Gallocyanin, Indigo und Phenothiazin umfaßt und welches sich von dem ersten Redoxmaterial durch ein Redoxpotential von zwischen 0,3 bis 1,0 V unterscheidet, wobei das erste und das zweite organische Redoxmaterial einen Heteroübergang zwischen sich ausbildet, und nur einer des ersten und zweiten Redoxaufbaus durch Licht anregbar ist; und
Anbringen einer zweiten Elektrode (5) auf dem zweiten Schichtaufbau,
wobei bei dem erhaltenen Umwandlungselement die Gegenwart eines einfallenden Lichtes auf diesen einen Aufbau einen Photostrom oder eine Photopsannung zwischen den Elektroden (2,5) erzeugt.

2. Photoelektrisches Umwandlungselement mit einer ersten Elektrode (2), einem ersten Schichtenaufbau (3) mit einer Dicke zwischen 1 und 50 nm, welcher aus einer oder mehreren geordneten, monomolekularen Schichten eines ersten organischen Redoxmaterials auf der ersten Elektrode besteht und irgendein Flavinderivat, Porphyrinderivat, Viologen, Methylenblau, Indophenol, Phenosafranin, Annulen, Neutralrot, Toluidinblau, Gallocyanin, Indigo und Phenothiazin umfaßt; einem in Kontakt mit dem ersten Schichtenaufbau (3) stehenden zweiten Schichtenaufbau (4), welcher einen separaten und diskreten Schichtenaufbau auf dem ersten Schichtenaufbau darstellt, wobei der zweite Schichtenaufbau (4) ebenfalls eine Dicke zwischen 1 und 50 nm aufweist und aus einer oder mehreren geordneten monomolekularen Schichten eines zweiten organischen Redoxmaterials besteht, welches irgendein Flavinderivat, Porphyrinderivat, Viologen, Methylenblau, Indophenol, Phenosafranin, Annulen, Neutralrot, Toluidinblau, Gallocyanin, Indigo und Phenothiazin umfaßt, und welches sich von dem ersten Redoxmaterial durch ein Redoxpotential von zwischen 0,3 und 1,0 V unterscheidet, wobei nur eines des ersten und zweiten Redoxmaterials durch Licht anregbar ist; und einer zweiten Elektrode (5) auf dem zweiten Schichtenaufbau (4), wobei das Element so ausgelegt ist, daß die Gegenwart eines einfallenden Lichtes auf den einen Aufbau einen Photostrom oder eine Photopsannung zwischen den Elektroden erzeugt.

3. Photoelektrisches Umwandlungselement nach Anspruch 2, dadurch gekennzeichnet, daß
der erste Schichtenaufbau (3) aus einem FlavinderivatRedoxmaterial besteht;
der zweite Schichtenaufbau (4) aus einem Porphyrinderivat-Redoxmaterial besteht;
das Flavinderivat der folgenden allgemeinen Formel (I) entspricht: 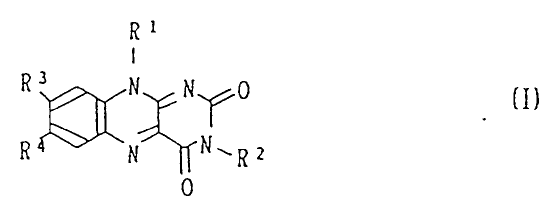 worin R¹, R² je ein Wasserstoffatom oder eine Alkylgruppe darstellen, wobei die folgenden Kombinationen umfaßt werden:
(i) R¹ ist ein Wasserstoffatom oder eine Alkylgruppe mit 1 bis 5 Kohlenstoffatomen,
R² ist eine Alkylgruppe mit 15 bis 20 Kohlenstoffatomen,
(ii) R¹ ist eine Alkylgruppe mit 6 bis 20 Kohlenstoffatomen,
R² ist eine Alkylgruppe mit 6 bis 20 Kohlenstoffatomen,
(iii) R¹ ist eine Alkylgruppe mit 15 bis 20 Kohlenstoffatomen,
R² ist ein Wasserstoffatom oder eine Alkylgruppe mit 1 bis 5 Kohlenstoffatomen,
und R³ und R⁴ sind je ein Substituent, welcher ein Wasserstoffatom, eine Alkylgruppe mit 1 bis 5 Kohlenstoffatomen oder eine Carbonylgruppe, eine Methylthioessigsäuregruppe oder eine Methylthiobernsteinsäuregruppe einschließt, und
das Porphyrinderivat ist ein Porphyrin-Metall-Komplex oder ein Alkalimetallsalz eines Porphyrin-Metall-Komplexes und entspricht einer der folgenden Formeln (II), (III) oder (IV): 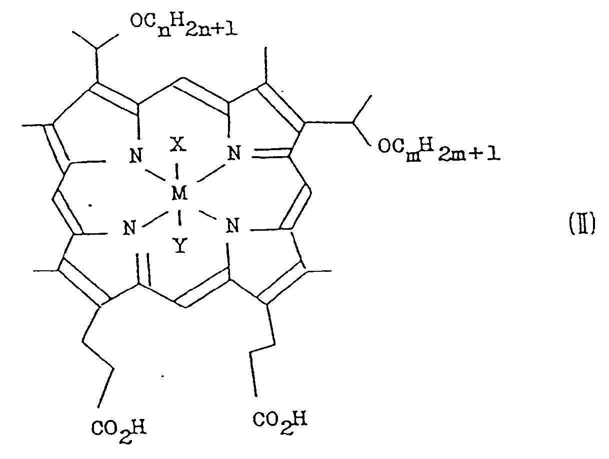 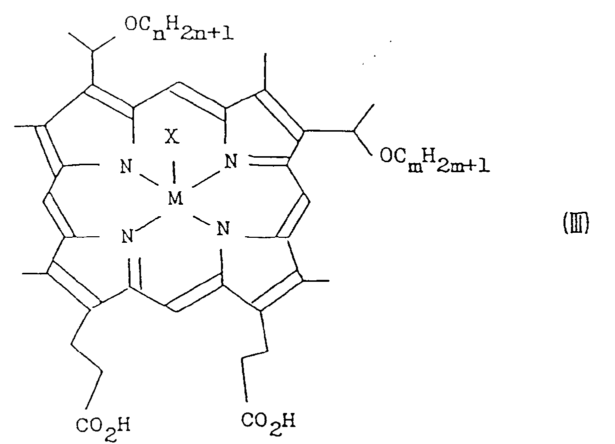 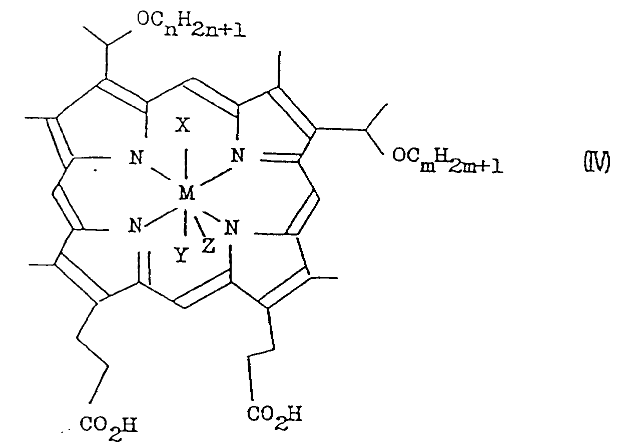 worin M für Fe oder Ru steht, X, Y und Z je einen Liganden von M darstellen, und die Struktur von (II), (III) und (IV) kann abhängig von der Art und der Wertigkeit von M erhalten werden, welche je ein Halogenatom, CO, -OCOCH₃, Pyridin, Imidazol, P(OR⁵)₃, oder PR⁵₃ (R⁵ steht für eine niedere Alkylgruppe von C1 bis C5) sind, und X und Y sind gleich oder verschieden, und m und n sind gleich oder verschieden.

4. Photoelektrisches Umwandlungselement nach Anspruch 3 worin:
der erste Schichtenaufbau (3) aus vier monomolekularen Schichten eines Flavinderivat-Redoxmaterials besteht, welches der folgenden Formel entspricht: 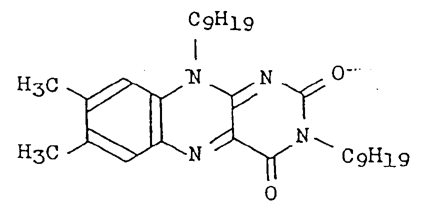 der zweite Schichtenaufbau (2) aus drei monomolekularen Schichten eines Porphyrinderivat-Redoxmaterials besteht, welches der folgenden Formel entspricht:

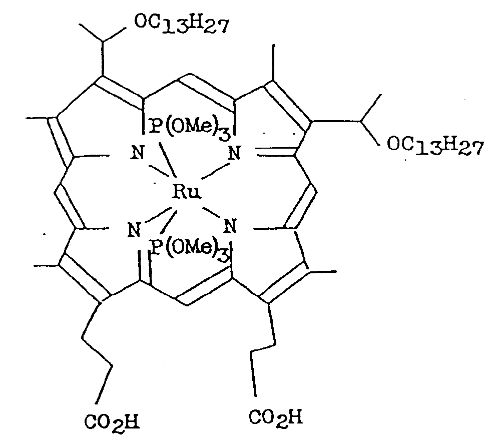

5. Photoelektrisches Umwandlungselement nach irgendeinem der Ansprüche 2 - 4 dadurch gekennzeichnet, daß
das erste und zweite Elektrodenmaterial eine Kombination aus einem oder zwei der folgenden Materialien umfaßt, wobei eine Elektrode aus einem lichtdurchlässigen, halbtransparenten Material hergestellt ist, welches aus Al, Ag, Au, Indium-Zinn-Oxid und SnO₂ hergestellt ist.

## Revendications

1. Méthode de production d'un élément de conversion photoélectrique ayant une hétérofonction moléculaire, comprenant :
la fourniture d'une première électrode (2);
la formation sur ladite première électrode d'une première structure (3) de couche d'une épaisseur entre 1 et 50 nm consistant d'une ou plusieurs couches moléculaires ordonnées d'un premier matériau rédox organique comprenant l'un d'un dérivé de flavine, d'un dérivé de porphyrine, de viologène, de bleu de méthylène, d'indophénol, de phénosafranine, d'annulène, de rouge neutre, de bleu de toluidine, de gallocyanine, d'indigo, et de phéno thiazine;
la formation sur ladite première structure de couche d'une seconde structure (4) de couche en contact avec ladite première structure (3) sous forme d'une structure de couche séparée et discrète, laquelle seconde structure (4) de couche a également une épaisseur entre 1 et 50 nm consistant d'une ou plusieurs couches monomoléculaires ordonnées d'un second matériau rédox organique qui comprend l'un parmi un dérivé de flavine, d'un dérivé de porphyrine, de viologène, de bleu de méthylène, d'indophénol, de phénosafranine, d'annulène, de rouge neutre, de bleu de toluidine, de gallocyanine, d'indigo, et de phéno thiazine et qui diffère dudit premier matériau redox par un potentiel rédox d'entre 0,3 à 1,0 V, lesdits premier et second matériaux redox organiques formant une hétérojonction entre eux, l'une seulement desdites première et seconde structure redox étant excitable par la lumière, et
l'application sur ladite seconde structure de couche d'une seconde électrode (5),
ce par quoi dans l'élément de conversion résultant la présence d'une lumière incidente sur ladite une structure produit un photocourant ou une phototension entre les électrodes (2,5).

2. Elément de conversion photoélectrique ayant une première électrode (2), une première structure (3) de couche d'une épaisseur entre 1 et 50 nm consistant d'une ou plusieurs couches monomoléculaires ordonnées d'un premier matériau rédox organique sur ladite première électrode et comprenant l'un d'un dérivé de flavine, d'un dérivé de porphyrine, de viologène, de bleu de méthylène, d'indophénol, de phéno safranine, d'annulène, de rouge neutre, de bleu de toluidine, de gallocyanine, d'indigo, et de phéno thiazine; une seconde structure (4) de couche en contact avec ladite première structure (3) de couche étant une structure de couche séparée et discrète sur ladite première structure de couche, laquelle seconde structure (4) de couche a également une épaisseur entre 1 et 50 nm et consiste d'une ou plusieurs couches monomoléculaires ordonnées d'un second matériau rédox organique qui comprend l'un d'un dérivé de flavine, d'un dérivé de porphyrine, de viologène, de bleu de méthylène, d'indophénol, de phénosafranine, d'annulène, de rouge neutre, de bleu de toluidine, de gallocyanine, d'indigo, et de phéno thiazine et qui diffère dudit premier matériau rédox par un potentiel rédox d'entre 0,3 et 1,0 V et l'un seulement desdits premier et second matériaux rédox étant excitables par la lumière, et une seconde électrode (5) sur ladite seconde structure (4) de couche, ledit élément étant adapté de sorte que la présence d'une lumière incidente sur ladite une structure produit un photocourant ou une phototension entre les électrodes.

3. Elément de conversion photoélectrique tel que revendiqué en revendication 2, caractérisé en ce que ladite première structure (3) de couche consiste d'un matériau rédox dérivé de flavine;
ladite seconde structure (2) de couche consiste d'un matériau rédox dérivé de porphyrine,
ledit dérivé de flavine est représenté par la formule générale (I) suivante : 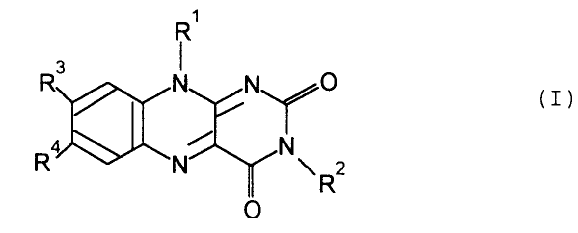 où R¹, R² sont chacun un atome d'hydrogène ou un groupe alkyle qui comprend la combinaison de ce qui suit :
(i) R¹ est un atome d'hydrogène ou un groupe alkyle ayant 1 à 5 atomes de carbone
R² est un groupe alkyle ayant 15 à 20 atomes de carbone
(ii) R¹ est un groupe alkyle ayant 6 à 20 atomes de carbone
R² est un groupe alkyle ayant 6 à 20 atomes de carbone
(iii) R¹ est un groupe alkyle ayant 15 à 20 atomes de carbone
R² est un atome d'hydrogène ou un groupe alkyle ayant de 1 à 5 atomes de carbone,
et R³ et R⁴ sont chacun un substituant incluant un atome d'hydrogène, un groupe alkyle ayant de 1 à 5 atomes de carbone, ou un groupe carbonyle, ou un groupe acide méthylthio acétique, ou un groupe acide méthylthio succinique, et
ledit dérivé porphyrine est un complexe métallique porphyrine, ou un sel métallique alcali d'un complexe métallique porphyrine, et est représenté par l'une des formules (II), (III) ou (IV) suivantes : 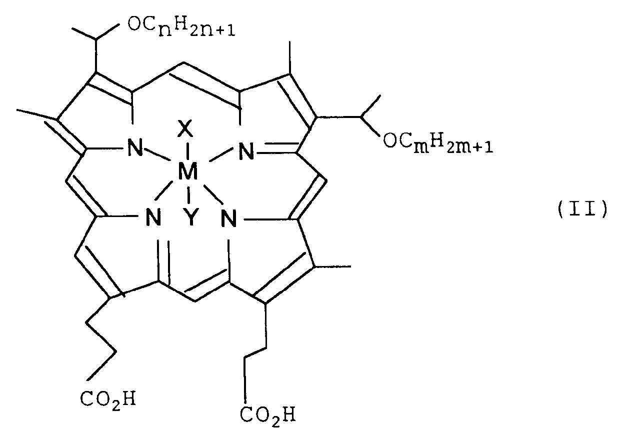 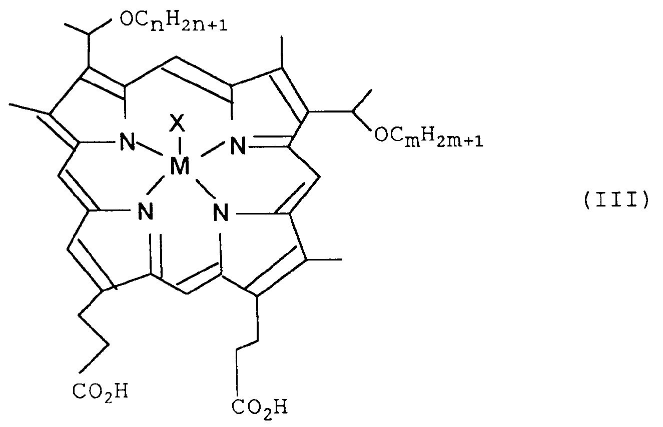 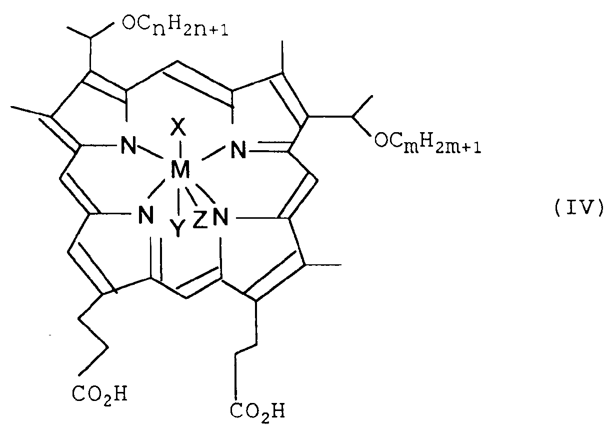 où M est Fe ou Ru, X, Y, et Z sont chacun un ligand envers M, et la structure de (II), (III), (IV) peut être obtenue selon les types et le nombre de liaisons de valence de M, qui sont, chacun un atome d'halogène, CO, -OCOCH₃, pyridine, imidazole, P(OR⁵)₃, ou PR⁵₃ (R⁵ représente un groupe alkyle inférieur en C1 à C5), et X et Y sont identiques ou différents et m et n sont identiques ou différents.

4. Elément de conversion photoélectrique tel que revendiqué à la revendication 3 où :
ladite première structure (3) de couche consiste de quatre couches mono-moléculaires d'un matériau rédox dérivé flavine représenté par la formule suivante : 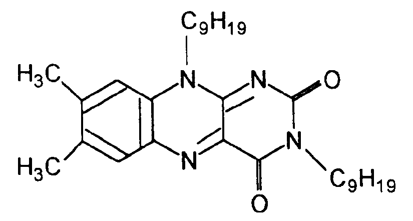 ladite seconde structure (2) de couche consiste de trois couches mono-moléculaires d'un matériau rédox dérivé de porphyrine représenté par la formule suivante :

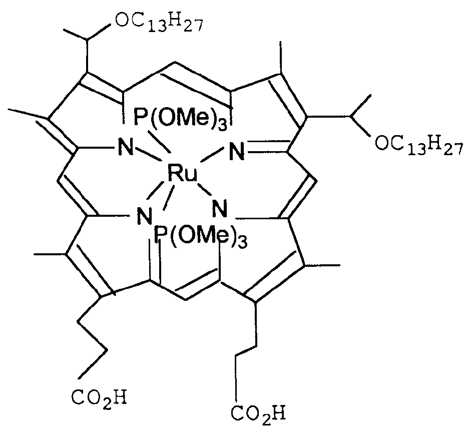

5. Elément de conversion photoélectrique tel que revendiqué dans l'une quelconque des revendications 2 à 4, caractérisé en ce que le premier et le second matériau d'électrodes comprend une combinaison de un ou deux des matériaux suivants, une électrode étant faite d'un matériau semi-transparent transmettant la lumière fait d'Al, Ag, Au, oxyde d'indium étain, SnO₂.
